# EUROPEAN PATENT APPLICATION

(11) **EP 4 507 480 A1**
(43) Date of publication of application: **12.02.2025**
(21) Application number: 23807658.2
(22) Date of filing: 17.05.2023
(51) Int. Cl.: H10N 30/02, B32B 7/022, B32B 7/025, H10N 30/20, H10N 30/30, H10N 30/857

(54) **LAYERED PIEZOELECTRIC FILM**

(30) Priority: 18.05.2022 JP 2022081449
(71) Applicant: Kureha Corporation, Chuo-ku Tokyo 103-8552 (JP)
(72) Inventor: SERIKAWA, Masahiro, Tokyo 103-8552 (JP); IMAJI, Makoto, Tokyo 103-8552 (JP)
(74) Representative: Hoefer & Partner Patentanwälte mbB
(86) International application number: PCT/JP2023/018369
(87) International publication number: WO 2023/224057

(57) **Abstract**

Provided is a laminated piezoelectric film having high rigidity and excellent thermal stability and smoothness. The laminated piezoelectric film includes a piezoelectric film and a protective film laminated on one surface of the piezoelectric film, in which a rigidity of the protective film is 1.0 times or more and 20 times or less the rigidity of the piezoelectric film, and a thickness of the protective film is 50 µm or more and 200 µm or less.

## Description

### TECHNICAL FIELD

The present invention relates to a laminated piezoelectric film.

### BACKGROUND ART

In recent years, a touch sensor has been introduced into an electronic device such as a smartphone or a tablet and is used as a human-machine interface that enables an intuitive operation. The touch sensor operates an electronic device by detecting a two-dimensional position touched by a finger or a pen (for example, see Patent Document 1).

In addition, in recent years, a touch sensor that detects a pressing force has been developed for the purpose of increasing input information and improving operability. For example, there are a method of detecting a pressing force based on a change in electrostatic capacitance when a housing is distorted or a change in resistance value using a pressure-sensitive rubber, a method of detecting a change in charge of a piezoelectric material, and the like. As a piezoelectric film of such a touch panel capable of detecting a pressing force (Z coordinate), for example, there is known a fluorine-based resin piezoelectric body containing polyvinylidene fluoride or polyvinylidene fluoride-tetrafluoroethylene copolymer as a main component.

### CITATION LIST

### PATENT DOCUMENT

Patent Document 1: JP H05-324203 A

### SUMMARY OF INVENTION

### TECHNICAL PROBLEM

However, as a result of studies by the present inventors, to enhance the piezoelectricity of the fluorine-based resin film, a stretching treatment or a thermal poling treatment of a film may be performed. Thus, the piezoelectric film subjected to the treatment tends to have large waviness on the surface thereof to lower smoothness as compared with a non-piezoelectric film such as a PET film due to the production method, and there is an issue that a defect may occur in a lamination process in production processes of a laminate using the piezoelectric film and the piezoelectric sensitivity of the laminate may be lowered.

As a result of intensive studies on the above issue, the present inventors have found that smoothness can be improved by laminating a protective film having high rigidity (hereinafter, a product of a tensile modulus of elasticity of a film and a thickness of the film is referred to as "rigidity") on a surface of a piezoelectric film.

In addition, in the laminated film in which the protective film is laminated on the piezoelectric film, the surface of the piezoelectric film is required to be smooth (smoothness), the laminated piezoelectric film is required not to be curled by heat treatment (high thermal stability) which may be performed in a process of laminating a conductive layer on the laminated film, and the laminated piezoelectric film is required not to be wrinkled by stress during transportation or the like (high rigidity).

The present invention has been made in light of the above issues and is directed to providing a laminated piezoelectric film having high rigidity, high thermal stability, and excellent smoothness.

### SOLUTION TO PROBLEM

The present inventors have found that the above-described issues can be solved by a laminated piezoelectric film including a protective film, in which for a rigidity B of the protective film and a rigidity A of the piezoelectric film, B/A satisfies a predetermined range, and a thickness of the protective film satisfies a predetermined range, and have completed the present invention. Specifically, the present invention relates to the following.

The present invention relates to a laminated piezoelectric film including a piezoelectric film and a protective film laminated on one surface of the piezoelectric film, in which a rigidity B of the protective film is 1.0 times or more and 20 times or less a rigidity A of the piezoelectric film, and a thickness of the protective film is 50 µm or more and 200 µm or less.

The thickness of the protective film is preferably 1.5 times or more a thickness of the piezoelectric film.

The rigidity B of the protective film is preferably 3.0 times or more and 20 times or less the rigidity A of the piezoelectric film.

The surface irregularity degree of a surface of the piezoelectric film on a side opposite the side on which the protective film is laminated is preferably 80 µm or less.

The piezoelectric film preferably contains polyvinylidene fluoride as a main component.

### ADVANTAGEOUS EFFECTS OF INVENTION

According to the present invention, it is possible to provide a laminated piezoelectric film having high rigidity and excellent thermal stability and smoothness.

### BRIEF DESCRIPTION OF THE DRAWINGS

FIG. 1 is a cross-sectional view schematically illustrating a laminated piezoelectric film 1, which is an embodiment of a laminated piezoelectric film according to the present invention.
FIG. 2 is a cross-sectional view schematically illustrating a laminated piezoelectric film 2, which is another embodiment of the laminated piezoelectric film according to the present invention.

### DESCRIPTION OF EMBODIMENTS

Hereinafter, embodiments of the present invention (hereinafter referred to as "the present embodiment") will be described in detail with reference to the drawings, but the present invention is not limited to these embodiments, and various modifications can be made without departing from the gist of the present invention.

In the present specification, "laminate" means that layers only need to be laminated in order and another layer may be laminated between the layers.

### Laminated Piezoelectric Film

A laminated piezoelectric film according to an embodiment of the present invention includes a piezoelectric film and a protective film laminated on one surface of the piezoelectric film, in which a rigidity B of the protective film is 1.0 times or more and 20 times or less of a rigidity A of the piezoelectric film, and a thickness of the protective film is 50 µm or more and 200 µm or less.

In particular, when the rigidity B of the protective film is 1.0 times or more and 20 times or less the rigidity A of the piezoelectric film, a laminated piezoelectric film having excellent thermal stability and smoothness is likely to be obtained. The rigidity of the film indicates resistance to deformation. It is presumed that when the rigidity B of the protective film and the rigidity A of the piezoelectric film are set to specific ranges, the protective film makes waviness of the piezoelectric film surface smooth, thereby reducing the irregularity degree of the piezoelectric film surface and suppressing curling of the laminated piezoelectric film due to processing heat.

### Properties of Laminated Piezoelectric Film, Protective Film, and Piezoelectric Film

In the laminated piezoelectric film, the rigidity B of the protective film is 1.0 times or more and 20 times or less the rigidity A of the piezoelectric film, and the thickness of the protective film is 50 µm or more and 200 µm or less.

When the rigidity of the protective film is less than 1.0 times the rigidity of the piezoelectric film, it is difficult to suppress the waviness of the piezoelectric film surface by the rigidity of the protective film, and the irregularity degree of the piezoelectric film surface increases, which is not preferable. Meanwhile, from the viewpoint of production processes such as transportation and winding, the rigidity of the protective film may be 10 times or less the rigidity of the piezoelectric film. The rigidity of the protective film is preferably 1.5 times or more and 20 times or less, more preferably 2.5 times or more and 20 times or less, even more preferably 3.0 times or more and 20 times or less, particularly preferably 5.0 times or more and 15 times or less, and most preferably 5.0 times or more and 10 times or less the rigidity of the piezoelectric film. When the rigidity of the protective film is 1.5 times or more the rigidity of the piezoelectric film, excellent thermal stability and smoothness are likely to be obtained.
A tensile modulus of elasticity of a film may vary depending on a measurement direction. In the present specification, the tensile modulus of elasticity of each of the protective film, the piezoelectric film, and the laminated piezoelectric film means the minimum value thereof. The tensile modulus of elasticity is measured in accordance with JIS K 7127 and is a value calculated based on 10.3 of JIS K 7161-1. Specifically, the tensile modulus of elasticity can be measured by a method described in examples described below.

A curl height of the laminated piezoelectric film by heating is a measure of the thermal stability of the film. The maximum height of the film reached by bending of the film from a film contact position is referred to as a curl height, and a smaller curl height indicates higher thermal stability. The curl height is preferably 20 mm or less, more preferably 15 mm or less, and even more preferably 10 mm or less.
In the present specification, the curl height of the laminated piezoelectric film can be measured according to a method described in the examples described below. Note that a curl height when a test piece becomes cylindrical as a result of a large degree of curl is considered to be greater than 20 mm.
The curl height of the laminated piezoelectric film can be appropriately adjusted by, for example, examining the thickness and tensile modulus of elasticity of the protective film, the thickness and tensile modulus of elasticity of the piezoelectric film, and a difference in linear expansion coefficient between the protective film and the piezoelectric film.

The thickness of the laminated piezoelectric film is preferably 50 µm or more and 300 µm or less, more preferably 100 µm or more and 300 µm or less, and even more preferably 150 µm or more and 250 µm or less. When the thickness of the film is 50 µm or more, the rigidity is likely to be sufficient. On the other hand, the thickness of the film is preferably 300 µm or less from the viewpoint of production processes such as transportation and winding.

The thickness of the protective film is preferably 50 µm or more and 200 µm or less, more preferably 70 µm or more and 200 µm or less, even more preferably 90 µm or more and 150 µm or less, and particularly preferably 110 µm or more and 150 µm or less. When the thickness of the protective film is 50 µm or more, higher rigidity is likely to be obtained, which makes excellent thermal stability and smoothness likely to be obtained.

**The** thickness of the piezoelectric film is preferably 10 µm or more and 200 µm or less, more preferably 20 µm or more and 200 µm or less, even more preferably 30 µm or more and 120 µm or less, and particularly preferably 30 µm or more and 80 µm or less. When the thickness of the film is 10 µm or more, the strength is likely to be sufficient. On the other hand, when the thickness of the film is 200 µm or less, sufficient transparency is likely to be obtained, which makes the film easy to be used in optical applications.

**The** thickness of the protective film is preferably 1.5 times or more and 10 times or less, and more preferably 2.0 times or more and 10 times or less the thickness of the piezoelectric film. When the thickness of the protective film is 1.5 times or more the thickness of the piezoelectric film, the rigidity of the protective film becomes dominant in the rigidity of the laminated piezoelectric film. The protective film is not subjected to a treatment for enhancing piezoelectricity as performed in the piezoelectric film. Accordingly, the protective film is excellent in thermal stability and smoothness, and thus, when the rigidity of the protective film becomes dominant in the rigidity of the laminated piezoelectric film, the laminated piezoelectric film is likely to obtain excellent thermal stability and smoothness.

The tensile modulus of elasticity of the protective film is preferably 1.0 GPa or more and 5.0 GPa or less, more preferably from 2.0 GPa or more and 5.0 GPa or less, and even more preferably 3.0 GPa or more and 5.0 GPa or less. When the tensile modulus of elasticity of the protective film is 1.0 GPa or more, rigidity is likely to increase, which makes excellent thermal stability and smoothness likely to be obtained. On the other hand, from the viewpoint of production processes such as transportation and winding, the tensile modulus of elasticity of the protective film may be 5.0 GPa or less.

The tensile modulus of elasticity of the piezoelectric film is preferably 0.5 GPa or more and 3.0 GPa or less, more preferably 1.0 GPa or more and 3.0 GPa or less, even more preferably 1.5 GPa or more and 3.0 GPa or less, and particularly preferably 1.5 GPa or more and 2.0 GPa or less. When the tensile elastic modulus of the piezoelectric film is in the numerical range, piezoelectricity is likely to be sufficient.

The rigidity of the laminated piezoelectric film is preferably 100 N/mm or more and 1000 N/mm or less, more preferably 200 N/mm or more and 1000 N/mm or less, even more preferably 300 N/mm or more and 1000 N/mm or less, and particularly preferably 400 N/mm or more and 1000 N/mm or less. When the rigidity of the laminated piezoelectric film is 100 N/mm or more, the film is likely to obtain excellent thermal stability and smoothness.

The rigidity of the protective film is preferably 100 N/mm or more and 1000 N/mm or less, more preferably 150 N/mm or more and 1000 N/mm or less, even more preferably 300 N/mm or more and 1000 N/mm or less, and particularly preferably 400 N/mm or more and 1000 N/mm or less. When the rigidity of the protective film is 100 N/mm or more, the laminated piezoelectric film using the film is likely to obtain excellent thermal stability and smoothness.

The rigidity of the piezoelectric film is preferably 10 N/mm or more and 200 N/mm or less, more preferably 50 N/mm or more and 200 N/mm or less, and even more preferably 50 N/mm or more and 150 N/mm or less. When the rigidity of the piezoelectric film is 10 N/mm or more, the laminated piezoelectric film using the film is likely to obtain high piezoelectricity.

A surface irregularity degree of a surface of the piezoelectric film on a side opposite the side on which the protective film is laminated is preferably 80 µm or less, more preferably 60 µm or less, even more preferably 40 µm or less, and particularly preferably 30 µm or less. When the surface irregularity degree on the surface of the film is 100 µm or less, excellent smoothness is likely to be obtained, which reduces defects in a lamination process using the film, and improves the piezoelectric sensitivity of the laminate obtained in the process.
In the present specification, the surface irregularity degree can be measured according to a method described in the examples described below. The surface irregularity degree in the present specification is not a value based on fine irregularities of a surface but a value based on waviness or wrinkles of the surface.
The surface irregularity degree can be appropriately adjusted by, for example, examining the thickness and tensile modulus of elasticity of the protective film, and the thickness and tensile modulus of elasticity of the piezoelectric film.

Next, each layer of the laminated piezoelectric film will be described with reference to drawings.

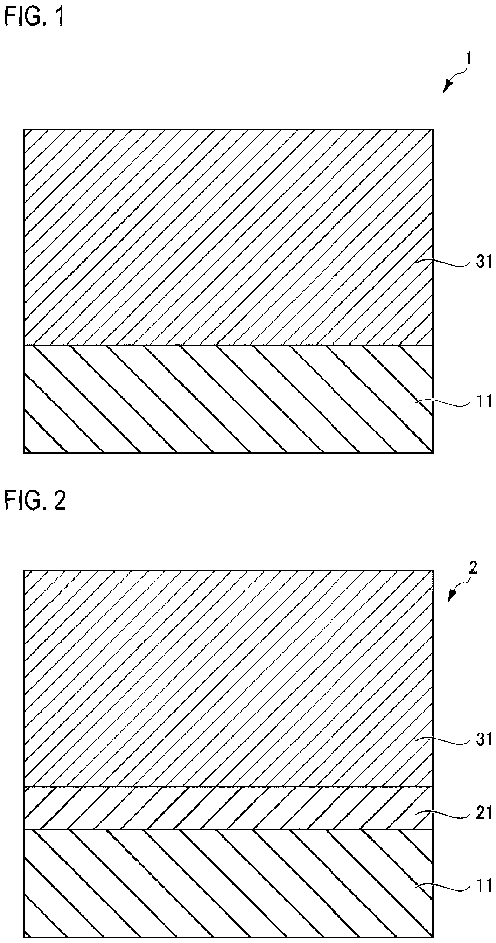

FIG. 1 is a cross-sectional view schematically illustrating a laminated piezoelectric film 1, which is an embodiment of the laminated piezoelectric film. In the laminated piezoelectric film 1, a protective film 31 is laminated on one surface of a piezoelectric film 11.
FIG. 2 is a cross-sectional view schematically illustrating a laminated piezoelectric film 2 that is another embodiment of the laminated piezoelectric film. The laminated piezoelectric film 2 is different from the laminated piezoelectric film 1 in that an adhesive layer 21 is provided between the piezoelectric film 11 and the protective film 31.

### Piezoelectric Film

The piezoelectric film 11 is a film (thin film) with piezoelectricity (a property of converting an applied force to a voltage or a property of converting an applied voltage to a force).

Examples of the piezoelectric film 11 include a polarized polar polymer compound capable of exhibiting piezoelectricity by orienting molecular dipoles by a polarization treatment generally called a thermal poling treatment, and a stretched chiral polymer compound capable of exhibiting piezoelectricity by applying a stretching treatment to a chiral polymer compound. Examples of the polarized polar polymer compound include a fluorine-based resin; a vinylidene cyanide polymer; a vinyl acetate-based polymer; an odd-numbered nylon such as nylon 9 or nylon 11; and polyurea. Examples of the stretched chiral polymer compound include a helical chiral polymer compound, such as polylactic acid; a polyhydroxycarboxylic acid, such as polyhydroxybutyrate; and a cellulose-based derivative. One of these can be used individually, or two or more can be used in combination. Among them, a fluorine-based resin is preferable from the viewpoint that the smoothness of the surface of the piezoelectric film is likely to be low and a smoothness improvement effect of the present invention is likely to be exhibited.
When the piezoelectric film is a uniaxially stretched film, the smoothness of the surface is likely to be low, which makes the smoothness improvement effect of the present invention likely to be exhibited. In addition, in a case where the piezoelectric film is a fluorine-based resin, when the degree of polarization is large, the smoothness of the surface is likely to be low, which makes the smoothness improvement effect of the present invention likely to be exhibited.

Examples of the fluorine-based resin include polyvinylidene fluoride (PVDF), vinylidene fluoride-based copolymers (e.g., vinylidene fluoride/trifluoroethylene copolymers, vinylidene fluoride/trifluoroethylene/chlorotrifluoroethylene copolymers, hexafluoropropylene/vinylidene fluoride copolymers, perfluorovinyl ether/vinylidene fluoride copolymers, tetrafluoroethylene/vinylidene fluoride copolymers, hexafluoropropylene oxide/vinylidene fluoride copolymers, hexafluoropropylene oxide/tetrafluoroethylene/vinylidene fluoride copolymers, and hexafluoropropylene/tetrafluoroethylene/vinylidene fluoride copolymers); tetrafluoroethylene-based polymers; and chlorotrifluoroethylene-based polymers. One of these can be used individually, or two or more can be used in combination. Among them, polyvinylidene fluoride or a vinylidene fluoride-based copolymer is preferably used as a main component, and polyvinylidene fluoride is more preferably used as a main component, from the viewpoint of high piezoelectricity, weather resistance, heat resistance, and the like. In the present specification, when a mass of a component constituting a certain polymer compound is 50 mass% or more relative to the total mass of polymer compounds (resins) constituting the piezoelectric film, the polymer compound is referred to as a main component.

The piezoelectric film 11 may further contain a commonly used additive (such as a filler and/or a surfactant).

### Protective Film

The protective film 31 is not particularly limited as long as it has the properties described above. Examples thereof include polyester resins such as polyethylene terephthalate (PET), polybutylene terephthalate(PBT), and polyethylene naphthalate (PEN); polyolefin resins such as polypropylene (PP) and polyethylene (PE); halogen-based polymers such as polyvinyl chloride (PVC) and polyvinylidene fluoride (PVDF); acrylic polymers such as polymethyl methacrylate; and styrene-based polymers such as polystyrene and styrene-methyl methacrylate copolymers. Among them, PET or PP is preferable, and PET is more preferable, from the viewpoint that the effects of the present invention can be more satisfactorily obtained. In addition, these films are preferably biaxially stretched films.

### Adhesive Layer

The laminated piezoelectric film according to an embodiment of the present invention may include an adhesive layer.

The laminated piezoelectric film 2 includes the adhesive layer 21 between the piezoelectric film 11 and the protective film 31. That is, the piezoelectric film 11 and the protective film 31 may be bonded to each other with the adhesive layer 21 interposed therebetween.

The adhesive layer is not particularly limited as long as it is easily peeled off from the piezoelectric film together with the protective film. For example, an acrylic resin or a rubber-based resin such as natural rubber or synthetic rubber can be used.

### Use of Laminated Piezoelectric Film

The laminated piezoelectric film according to an embodiment of the present invention is suitably used for a device such as a piezoelectric panel including a touch panel of a capacitance type, a resistance film type, or the like, a pressure sensor, an actuator for a haptic device, a piezoelectric vibration power generation device, or a flat speaker, after the protective film is peeled off.

The device may further include a common display panel unit, such as an LCD, under the piezoelectric film.

The device is suitably used in smartphones, mobile information terminals, tablet PCs, notebook personal computers, medical devices, car navigation systems, and the like.

### Method for Producing Laminated Piezoelectric Film

The laminated piezoelectric film according to the present embodiment can be produced by a method including (1) a process of producing the piezoelectric film and (2) a process of bonding the protective film, and the like.

### (1) Process of producing piezoelectric film

A method for producing the piezoelectric film is not particularly limited, and the piezoelectric film can be produced by, for example, the following method.

In a case where a piezoelectric film containing a fluorine-based resin is produced, the piezoelectric film can be obtained through a process of subjecting a film containing a fluorine-based resin to a polarization treatment. The film containing a fluorine-based resin may be a stretched film or an unstretched film. In the present embodiment, from the viewpoint of exhibiting a high piezoelectric effect, it is preferable to stretch the film containing a fluorine-based resin and then subject the stretched film to the polarization treatment.

The film containing a fluorine-based resin can be produced by an arbitrary method such as a melt-extrusion method or a solution-casting method. Among them, from the viewpoint of easily obtaining a piezoelectric film having a predetermined thickness or more, it is preferable that the film containing a fluorine-based resin is produced by the melt-extrusion method. In the melt-extrusion method, the fluorine-based resin and an optional additive can be heated and melted in a cylinder of an extruder and then extruded from a die to obtain a film.

The obtained film has a structure in which an α-type crystal (the main chain has a helical structure) and a β-type crystal (the main chain has a planar zigzag structure) are mixed. The β-type crystal has a large polarization structure. When the film is stretched, the α-type crystal can be converted into the β-type crystal. In the stretching process, the film is preferably stretched as necessary to convert the fluorine-based resin into the β-type crystal. The stretching direction may be a TD direction or an MD direction, and is more preferably the MD direction.

The stretching method is not particularly limited, and can be performed by a known stretching method such as a tenter method or a drum method.

A stretching ratio may be, for example, 3.0-fold or more and 6.0-fold or less. When the stretching ratio is 3.0-fold or more, it is easy to adjust the thickness and polarizability of the film to more appropriate ranges. When the stretching ratio is 3.0-fold or more, dislocation of the β-type crystal becomes more sufficient, which can not only make higher piezoelectricity likely to be exhibited but also further enhance transparency. When the stretching ratio is 6.0-fold or less, it is possible to further suppress breakage due to stretching.

**The** obtained stretched film is subjected to a polarization treatment. The polarization treatment can be performed by, for example, applying a direct voltage between a ground electrode and a needle-shaped electrode. The voltage only needs to be adjusted depending on the thickness of the stretched film, and may be, for example, 1 kV or more and 50 kV or less.

As described above, in the present embodiment, the piezoelectric film can be obtained by subjecting the stretched film to the polarization treatment.

### (2) Process of bonding protective film

The protective film may be a commercially available product or may be produced. The protective film is preferably a film having a high tensile modulus of elasticity from the viewpoint of enhancing the smoothness of the surface of the piezoelectric film. Specifically, a protective film having the above-described tensile modulus of elasticity and type can be used.

A method for bonding the protective film is not particularly limited, and examples thereof include a method in which the protective film and the piezoelectric film are bonded to each other with an adhesive layer interposed therebetween using a laminator or the like. In a case where the protective film has self-adhesiveness, the protective film and the piezoelectric film may be bonded to each other without the adhesive layer interposed therebetween. In a case where the adhesive layer is interposed, the protective film on which the adhesive layer is formed may be bonded to the piezoelectric film, or the adhesive layer may be formed on the piezoelectric film and then the protective film may be bonded thereto.

### EXAMPLES

The present invention will be further described with reference to examples and comparative examples below, but the present invention is not limited to these examples.
The properties of the laminated piezoelectric film according to the present invention were measured by the following methods, and the results are indicated in Table 1.

### Tensile modulus of elasticity

The tensile modulus of elasticity of each of the piezoelectric film, the protective film, and the laminated piezoelectric film was measured in accordance with JIS K 7127. A test piece cut to have 10 mm × 100 mm in such a manner that the long side was parallel to the machine direction (MD) was used, and the measurement was performed under conditions of a tensile speed of 50 mm/min and a distance between chucks of 50 mm. The tensile modulus of elasticity at this time was calculated based on 10.3 of JIS K 7161-1.

Note that the tensile modulus of elasticity was calculated in the same manner using a test piece cut in such a manner that the long side was parallel to another direction such as the transverse direction (TD). However, the tensile modulus of elasticity in the machine direction was the minimum in all examples and comparative examples.

### Curl height

A test piece obtained by cutting the laminated piezoelectric film into a 10 cm square was used and put into an oven set at 50°C for 1 minute to perform a heat treatment. Thereafter, lifting amounts of four corners of the heat-treated test piece in the vertical direction were measured, and the maximum height was defined as a curl height (mm).

### Surface irregularity degree

A surface irregularity degree (µm) of the laminated piezoelectric film was measured using a 3D profilometer VR-5000 (available from KEYENCE CORPORATION).

On a stainless steel plate (thickness: 1 mm) of 20 cm × 30 cm, a test piece cut to have a similar size was placed with the piezoelectric film surface facing up. The centers of the long sides of the test piece were pressed with magnets without applying tension, and then the four corners were fixed with tapes.

As a pre-treatment, a reference plane was set using a designated region (75 mm × 140 mm) and noise removal was set to middle.

The measurement was performed by photographing the designated region with a low magnification camera. The measurement was performed under conditions that the mode was a plural line roughness mode, the number of lines was 11, the interval was 100 lines, the region was a horizontal line and a vertical line, and there was no cutoff, and an arithmetic average height Ra of a total of 22 lines was obtained.

The measurement was performed three times in total while the test piece was reset each time, and the arithmetic average value of the three times was obtained as the surface irregularity degree.

### Examples 1 to 2 and Comparative Examples 1 to 4

A resin film (thickness 120 µm) formed from polyvinylidene fluoride (available from Kureha Corporation) having an inherent viscosity of 1.1 dl/g was stretched uniaxially in a stretching ratio of 4.2 times. After the stretching, the film was subjected to the polarization treatment by applying a DC voltage between a ground electrode and a needle-shaped electrode while the DC voltage was increased from 0 kV to 12.0 kV to obtain a piezoelectric film. The film after the polarization treatment was further heat-treated at 130°C for 1 minute, and a piezoelectric film with a thickness of 40 µm was obtained. The tensile modulus of elasticity of the piezoelectric film was 1812 MPa, and the product of the thickness and the tensile modulus of elasticity was 72.5 N/mm.

Next, a laminated film in which an adhesive layer was formed on the protective film described in Table 1 and the piezoelectric film were bonded to each other using a laminator and then wound in a roll shape to obtain a laminated piezoelectric film. For the laminator, the line speed was set to 5 m/min, and the laminate roll contact pressure was set to approximately 0.3 N.

**[Table 1]**

| | | Example 1 | Example 2 | Comparative Example 1 | Comparative Example 2 | Comparative Example 3 | Comparative Example 4 |
|---|---|---|---|---|---|---|---|
| Piezoelectric film | Thickness [µm] | 40 | 40 | 40 | 40 | 40 | 40 |
| | Modulus of elasticity [MPal | 1812 | 1812 | 1812 | 1812 | 1812 | 1812 |
| | Rigidity A [N/mm] | 72.5 | 72.5 | 72.5 | 72.5 | 72.5 | 72.5 |
| Protective film | Type of resin | PET | PET | None | PET | PP | PE |
| | Thickness [µm] | 75 | 125 | - | 38 | 30 | 60 |
| | Modulus of elasticity [MPal | 4043 | 3893 | - | 3856 | 551 | 439 |
| | Rigidity B [N/mm] | 303.2 | 486.6 | - | 146.5 | 16.5 | 26.3 |
| B/A | | 4.18 | 6.71 | - | 2.02 | 0.23 | 0.36 |
| Laminated piezoelectric film | Rigidity [N/mm] | 384.8 | 570.3 | 72.5 | 188.2 | 93.9 | 86.6 |
| | Curl height [mm] | 20 | 5 | - | Cylindrical shape | 0 | Cylindrical shape |
| Surface irregularity degree of piezoelectric film | Ra [µm] | 41.1 | 27.2 | 139.6 | 88.0 | 144.5 | 120.5 |

| | | | | | | | |
|---|---|---|---|---|---|---|---|
| (The product of the thickness and the tensile modulus of elasticity is referred to as rigidity.) | | | | | | | |

As indicated in Table 1, in the examples, the product of the thickness and the tensile modulus of elasticity of the laminated piezoelectric film was high, the curl height was low, and the surface irregularity degree was low. Accordingly, it has been confirmed that it is possible to obtain a laminated piezoelectric film having high rigidity and excellent thermal stability and smoothness by the present invention.

### REFERENCE SIGNS LIST

1, 2: Laminated piezoelectric film, 11: Piezoelectric film, 21: Adhesive layer, 31: Protective film

## Claims

1. A laminated piezoelectric film comprising: a piezoelectric film; and a protective film laminated on one surface of the piezoelectric film,
wherein a rigidity of the protective film is 1.0 times or more and 20 times or less a rigidity of the piezoelectric film, and
a thickness of the protective film is 50 µm or more and 200 µm or less.

2. The laminated piezoelectric film according to claim 1, wherein the thickness of the protective film is 1.5 times or more a thickness of the piezoelectric film.

3. The laminated piezoelectric film according to claim 1 or 2, wherein the rigidity of the protective film is 3.0 times or more and 20 times or less the rigidity of the piezoelectric film.

4. The laminated piezoelectric film according to claim 1 or 2, wherein a surface irregularity degree of a surface of the piezoelectric film on a side opposite the side on which the protective film is laminated is 80 µm or less.

5. The laminated piezoelectric film according to claim 1 or 2, wherein the piezoelectric film comprises polyvinylidene fluoride as a main component.
